# EUROPEAN PATENT APPLICATION

(11) **EP 3 993 079 A1**
(43) Date of publication of application: **04.05.2022**
(21) Application number: 20882599.2
(22) Date of filing: 16.10.2020
(51) Int. Cl.: H01L 51/52, H01L 27/32

(54) **DISPLAY APPARATUS AND ELECTRONIC DEVICE**

(30) Priority: 31.10.2019 CN 201911049564
(71) Applicant: GUANGDONG OPPO MOBILE TELECOMMUNICATIONS CORP., LTD., Dongguan, Guangdong 523860 (CN)
(72) Inventor: YUAN, Shilin, Dongguan, Guangdong 523860 (CN)
(74) Representative: Penza, Giancarlo
(86) International application number: PCT/CN2020/121487
(87) International publication number: WO 2021/082949

(57) **Abstract**

A display apparatus and an electronic device. The display apparatus comprises a first display area and a second display area, which adjoin each other, wherein the light transmittance of the first display area is greater than the light transmittance of the second display area; the first display area comprises a metal anode layer and a drive circuit layer, which are electrically connected to each other; the metal anode layer comprises a plurality of metal anodes; the drive circuit layer comprises a plurality of first drive units; and at least part of the orthographic projection of at least one first drive unit on the metal anode layer is located in a metal anode.

## Description

### CROSS-REFERENCE TO RELATED APPLICATIONS

The present application claims priority to a Chinese application No. 201911049564.3, filed in the China National Intellectual Property Administration on October 31, 2019, titled "DISPLAY APPARATUS AND ELECTRONIC DEVICE". The entire contents of the above-mentioned application are incorporated herein by reference.

### TECHNICAL FIELD

The disclosure relates to the electronic technical field, and particularly to a display apparatus and an electronic device.

### BACKGROUND

With the development of communication technology, electronic devices such as mobile phones are more and more popular. During operation, an electronic device may display images with its display apparatus.

For achieving better display effect and user experience, the size of screen is designed to become larger and larger. However, it is difficult for the user to hold the electronic device if the screen size of the electronic device surpasses a certain size. Thus, it is becoming more and more important to increase screen-to-body ratio of the screen.

### SUMMARY

The disclosure provides a display apparatus and an electronic device, and aims to increase the light transmittance of the display apparatus.

In an aspect, the disclosure provides a display apparatus. The display apparatus includes a first display area and a second display area which adjoin each other. A light transmittance of the first display area is larger than a light transmittance of the second display area. The first display area includes a metal anode layer and a drive circuit layer electrically connected to the metal anode layer. The metal anode layer includes multiple metal anodes, and the drive circuit layer includes multiple first drive units. An orthographic projection of at least one of the first drive units on the metal anode layer is at least partially located within one of the metal anodes.

In another aspect, the disclosure provides an electronic device. The electronic device includes a display apparatus and a camera. The display apparatus includes a first display area and a second display area which adjoin each other. A light transmittance of the first display area is greater than a light transmittance of the second display area. The first display area includes a metal anode layer and a drive circuit layer electrically connected to the metal anode layer. The metal anode layer includes multiple metal anodes, and the drive circuit layer includes multiple first drive units. An orthographic projection of at least one of the first drive units on the metal anode layer is at least partially located within one of the metal anodes. The camera includes a lens. The lens is arranged to face the first display area, and the camera is configured to acquire a signal of external light passing through the first display area for imaging.

### BRIEF DESCRIPTION OF THE DRAWINGS

In order to more clearly illustrate technical solutions in the embodiments of the disclosure, drawings used in the description of the embodiments will be briefly described below. Obviously, the drawings in the following description are merely some embodiments of the disclosure. For those skilled in the art, other drawings may also be obtained based on these drawings without paying any creative work.
FIG. 1 illustrates a structural schematic diagram of an electronic device according to embodiments of the disclosure.
FIG. 2 is a schematic diagram illustrating a first structure of the display apparatus of an electronic device according to the embodiments of the disclosure.
FIG. 3 is a schematic diagram illustrating a first stacked structure of a first display area of the display apparatus according to the embodiments of the disclosure.
FIG. 4 is an enlarged view of a portion Y of FIG. 2.
FIG. 5 is a schematic diagram illustrating a second stacked structure of the first display area of the display apparatus according to the embodiments of the disclosure.
FIG. 6 is a schematic diagram illustrating a third stacked structure of the first display area of the display apparatus according to the embodiments of the disclosure.
FIG. 7 is an exemplary enlarged view of a portion X illustrated in FIG. 2.
FIG. 8 is another exemplary enlarged view of the portion X illustrated in FIG. 2.
FIG. 9 is yet another exemplary enlarged view of the portion X illustrated in FIG. 2.
FIG. 10 is a structural schematic diagram of first pixels and first drive units of the display apparatus according to the embodiments of the disclosure.
FIG. 11 is a structural schematic diagram of second pixels and second drive units of the display apparatus according to the embodiments of the disclosure.
FIG. 12 is a schematic diagram illustrating a second structure of the display apparatus of the electronic device according to the embodiments of the disclosure.
FIG. 13 is a schematic diagram of a fourth stacked structure of the first display area of the display apparatus according to the embodiments of the disclosure.
FIG. 14 is a structural schematic diagram of the display apparatus and a camera according to the embodiments of the disclosure.
FIG. 15 is another structural schematic diagram of the display apparatus and the camera according to the embodiments of the disclosure.

### DETAILED DESCRIPTION

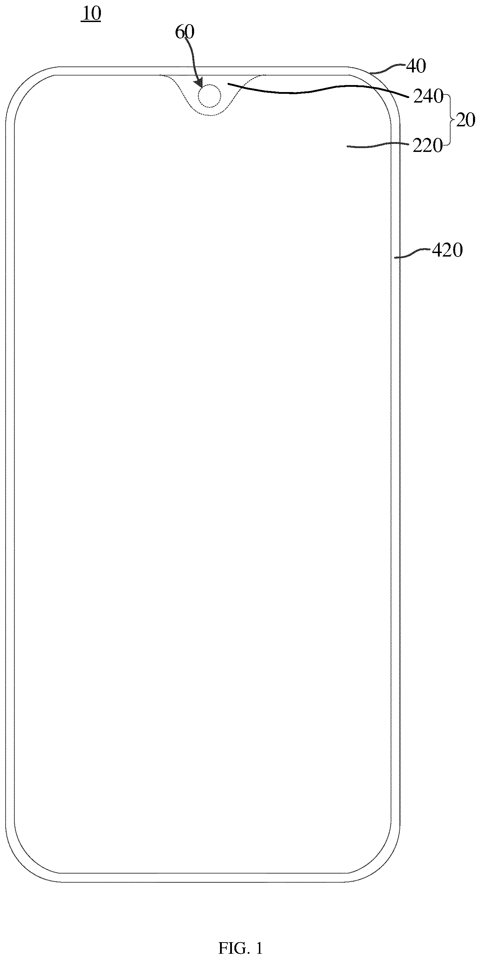

The technical solutions in the embodiments of the disclosure will be clearly and completely described below in conjunction with the FIGS. 1 to 15 in the embodiments of the disclosure. Apparently, the described embodiments are only a part rather than all of the embodiments of the disclosure. All other embodiments, which are obtained by those skilled in the art based on the embodiments of the disclosure without paying any creative efforts, should fall within the scope of the disclosure.

The disclosure provides an electronic device and a display apparatus. The electronic device includes the display apparatus and a camera. A lens of the camera is arranged opposite the display apparatus, that is, the camera is configured to acquire a signal of external light that passes through the display apparatus for imaging. It can be understood that, the light transmittance of the existing display apparatus is relatively low, and the imaging effect of the camera that images with the light passing through the display apparatus is poor. In view of this, in the disclosure, the display apparatus is divided into different areas in such a manner that for example the light transmittance of a portion of the display apparatus corresponding to the camera is made greater than the light transmittance of other portions of the display apparatus, which can improve the imaging effect of the camera. The technical solutions in the embodiments of the disclosure will be clearly and completely described below in conjunction with the drawings in the embodiments of the disclosure.

Embodiments of the disclosure provide a display apparatus and an electronic device. The display apparatus is applied to the electronic device. The electronic device may be a mobile terminal device such as a mobile phone and a tablet, and may also be a device including a display apparatus, such as gaming device, augmented reality (AR) device, virtual reality (VR) device, vehicle onboard computer, laptop, data storage device, audio display apparatus, video display apparatus, and wearable device, in which the wearable device may be a smart bracelet, smart glasses or the like.

Referring to FIG. 1, a structural schematic diagram of an electronic device according to the embodiments of the disclosure is illustrated. The electronic device in FIG. 1 is exemplarily illustrated as a cell phone. The display apparatus 20 includes a second display area 220 and a first display area 240. The light transmittance of the first display area 240 is greater than the light transmittance of the second display area 220. The electronic device 10 is provided therein with a camera 60. A lens of the camera 60 is arranged to face the first display area 240, and the camera 60 is configured to acquire a signal of external light passing through the first display area 240 for imaging. In other words, the camera 60 is arranged beneath the first display area 240 of the display apparatus 20, and the camera 60 is configured to acquire the signal of external light passing through the first display area 240 of the display apparatus 240, and to produce an image based on the acquired external light. The display area of the display apparatus 20 is an integral area, thereby increasing a screen-to-body ratio of the display apparatus 20. The camera 60 may serve as a front camera of the electronic device 10. The camera 60 may be configured to produce images such as a user's selfie with light passing through the first display area 240 of the display apparatus 20.

In order to more comprehensively understand the display apparatus provided by the embodiments of the disclosure, details of the display apparatus will be described below.

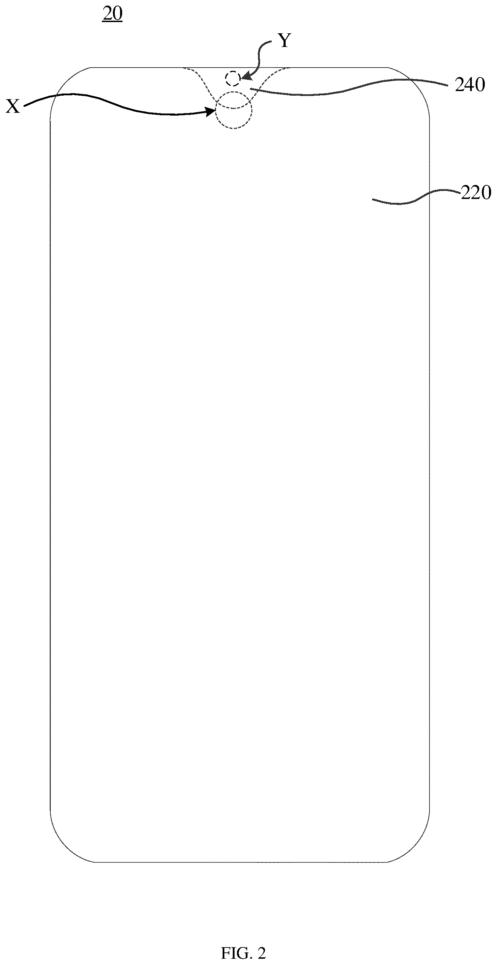

Referring to FIG. 2, a schematic diagram illustrating a first structure of a display apparatus of the electronic device according to the embodiments of the disclosure is illustrated. The display apparatus 20 may include a second display area 220 and a first display area 240 which adjoin each other. The second display area 220 and the first display area 240 may both be configured to display texts or images. The second display area 220 and the first display area 240 may be configured to cooperatively display a same image. For example, the second display area 220 may display a portion of a preset image, and the first display area 240 may display the remaining portion of the preset image. The second display area 220 and the first display area 240 may also be configured to display different images. For example, the second display area 220 may display a preset image, and the first display area 240 may display a taskbar image. The second display area 220 and the first display area 240 may both be configured to display contents. In this way, the display area is complete, and a relatively high screen-to-body ratio of the display apparatus 20 is provided. The second display area 220 may be arranged to surround the first display area 240, and the entire periphery of the first display area 240 may be adjoined to the second display area 220. In other words, the first display area 240 may be located in the second display area 220. The second display area 220 may be arranged to partially surround the first display area 240, that is, a part of the periphery of the first display area 240 may be adjoined to the second display area 220. For example, the first display area 240 may be located at a corner of the display apparatus 20 or at the middle of the top of the display apparatus 20.

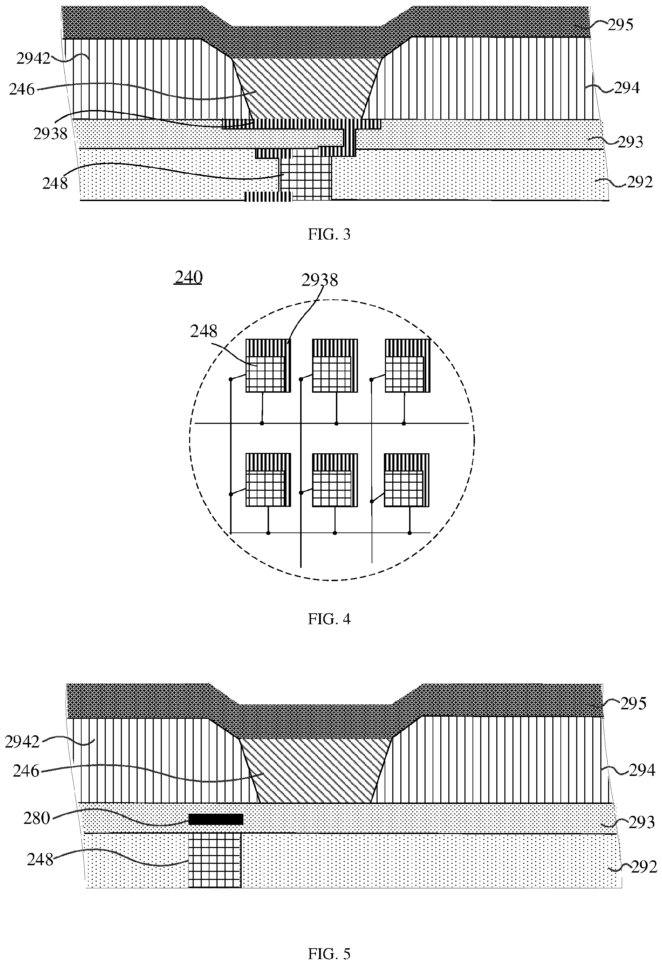

Referring to FIG. 3, a schematic diagram illustrating a stacked structure of the first display area of the display apparatus according to the embodiments of the disclosure is illustrated. The first display area of the display apparatus includes a drive circuit layer 292, a metal anode layer 293, a light-emitting layer 294, and a common electrode layer 295 which are stacked in sequence. The drive circuit layer 292 includes multiple first drive units 248, and the multiple first drive units 248 are configured to drive the light-emitting layer 294. The first drive units 248 include opaque parts such as thin-film transistors (TFT).

The metal anode layer 293 may be partially or entirely arranged on the drive circuit layer 292. The metal anode layer 293 is connected with the drive circuit layer 292, and is configured to control each of the first driver units 248 of the drive circuit layer 292. The metal anode layer 293 may be arranged to be adjacent to the light-emitting layer 294. The metal anode layer 293 includes multiple metal anodes 2938. The metal anodes 2938 of the metal anode layer 293 are directly adjacent to and electrically connected to first pixels 246 of the light-emitting layer 294. The metal anodes 2938 may be made from opaque materials such as magnesium (Mg), silver (Ag), or aluminum (Al).

The light-emitting layer 294 is arranged on the metal anode layer 293. The light-emitting layer 294 includes a pixel definition layer 2942 which is provided with multiple pixels holes. Each pixel hole is provided therein with a first pixel 246, and the first pixel 246 is made from an organic light-emitting material.

The common electrode layer 295 is arranged on the light-emitting layer 294. The metal anode layer 293 and the common electrode layer 295 is arranged at two sides of each of the first pixels 246, and drive the first pixels 246 cooperatively with the multiple first drive circuits 248 of the drive circuit layer 292. Each of the first drive units 248 may drive at least one first pixel 246. For example, each of the first drive units 248 may drive one first pixel 246, or each of the first drive units 248 may drive two first pixels 246 connected in parallel.

In the process that the camera acquires the signal of external light passing through the first display area for imaging, since the first drive units 248 of the drive circuit layer 292 of the first display area include opaque parts which are not transparent to light, such as thin-film transistors and the metal anodes 2938 of the metal anode layer is made from an opaque material, the light transmittance of the first display area is influenced by the first drive units 248 and the metal anodes 2938 of the first display area. Referring to FIG. 4 which is an enlarged view of a portion Y illustrated in FIG. 2, at least a part of an orthographic projection of at least one of the first drive units 248 on the metal anode layer is located within one of the metal anodes 2938. In other words, at least one of the metal anodes 2938 partly or fully covers one of the first drive units 248. By making each metal anode 2938 and the respective first drive unit 248 overlap partly or fully with each other, the area of opaque parts of the first display area 240 caused by the first drive units 248 can be reduced, thereby increasing the light transmittance of the first display area 240. Further, when the metal anodes 2938 fully covers the first drive units 248, diffraction generated at the periphery of the first drive units 248 can be reduced during photographing.

In addition, in the process that the camera acquires the signal of external light passing through the first display area for imaging, since the first drive units 248 of the drive circuit layer 292 of the first display area include opaque parts such as thin-film transistors, the external light is reflected or refracted when arriving at the first drive units 248 to generate unwanted light, which influences the imaging effect of the camera. By arranging the first drive units 248 in such a way that the orthographic projection of each of the first drive units 248 on the metal anode layer is located within one of the metal anodes 2938, each of the metal anodes 2938 covers a corresponding drive unit 248. As such, the metal anodes 2938 may block the signal of external light from arriving at the first drive units 248, thereby reducing unwanted light that is caused by reflection and/or refraction of the first drive unit 248. When the camera acquires the signal of external light passing through the first display area for imaging, the metal anodes 2938 can enable the interruption of the unwanted light to be reduced, and thus the imaging quality of the camera can be improved.

Referring to FIG. 3, in the embodiments of the disclosure, the multiple metal anodes 2938 are spaced apart from each other, and an orthographic projection of the first pixel 246 on the metal anode layer covers the respective metal anode 2938. By controlling the area of the metal anode 2938, the area of the first display area occupied by the metal anodes 2938 can be reduced, and thus the light transmittance of the first display area can be further increased.

Referring to FIG. 5, a schematic diagram illustrating a second stacked structure of the first display area of the display apparatus according to the embodiments of the disclosure is illustrated. It can be understood that, in other embodiments, for reducing the interruption of the unwanted light that is caused by the reflection and/or refraction of the first drive units 248, the metal anodes 2938 may also do not cover the first drive units 248, rather, a light-blocking member 280 is arranged between the first drive unit 292 and the light-emitting layer 294. At least a portion of the light-blocking member 280 is arranged opposite the first drive unit 248. In other words, an orthographic projection of the light-blocking member 280 on the drive circuit layer 292 covers the first drive unit 248. The light-blocking member 280 may also block the signal of external light from arriving at the first drive unit 248, thereby reducing the interruption of the unwanted light that is caused by reflection and/or refraction of the first drive unit 248. In the process that the camera acquires the external light passing through the first display area for imaging, the light-blocking member 280 enables the interruption of the unwanted light to be reduced, and thus the imaging quality of the camera can be improved. Specifically, the light-blocking member 280 may be made from a black light-absorbing material. The shape, size and arrangement of the light-blocking members 280 may be set according to the first drive units 248.

Exemplarily, the orthographic projection of the light-blocking member 280 on the drive circuit layer 292 may cover the respective first drive unit 248. That is, the size of the light-blocking member 280 is greater than or equal to the size of the first drive unit 248, and the light-blocking member 280 is directly above the first drive unit 248. In other words, when the external light enters the first display area in a direction perpendicular to the first display area, the light-blocking member 280 exactly prevents the external light from arriving at the first drive unit 248. The size of the light-blocking member 280 may be slightly greater than the size of the first drive unit 248, and thus the light-blocking member 280 may better prevent the external light from arriving at the first drive unit 248 and reduce the unwanted light caused by the first drive unit 248 as far as possible. The light-blocking members and the first drive units 248 may be arranged in a one-to-one correspondence, with one light-blocking member 280 opposite to one corresponding first drive unit 248.

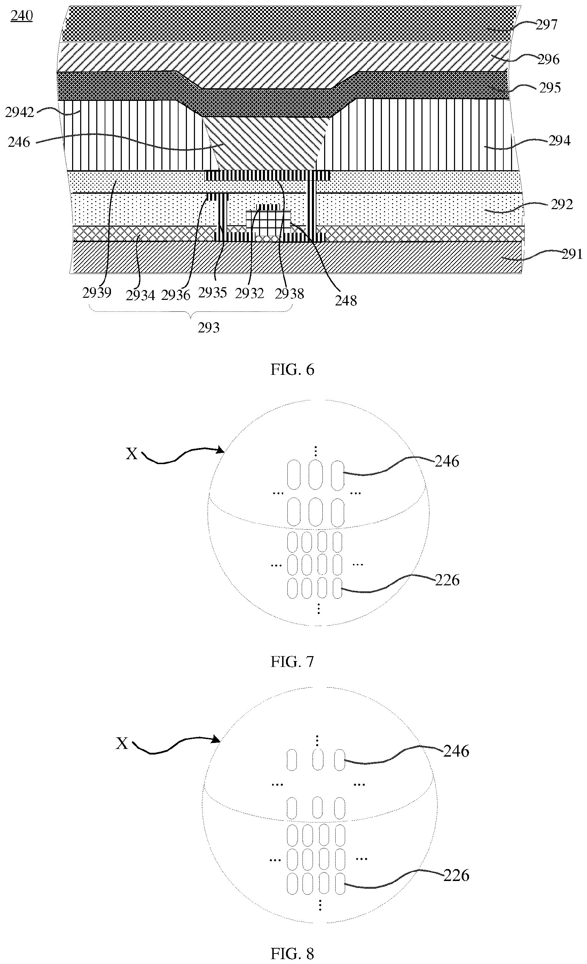

For more comprehensively understanding the display apparatus in the embodiments of the disclosure, referring to FIG. 6, a schematic diagram illustrating a third stacked structure of the first display area of the display apparatus according to the embodiments of the disclosure is shown. The first display area 240 of the display apparatus includes a substrate 291, a drive circuit layer 292, a metal anode layer 293, a light-emitting layer 294, a common electrode layer 295, a planarization layer 296, and a touch-sensitive layer 297 which are stacked in sequence.

The substrate 291 may serve as a support platform of the display apparatus. The substrate 291 may be made from glass, plastic, resin or other materials. For example, the substrate 291 may be made from polyimide (PI). The drive circuit layer 292 is arranged on the substrate 291. The drive circuit layer 292 include first drive units 248 configured to drive first pixels 246 of a first display area 240. Each of the first drive units 248 includes at least one TFT. A source electrode and a drain electrode of the TFT are arranged at a same layer, and the gate electrode is arranged between the source electrode and the light-emitting layer.

The metal anode layer 293 is arranged on the drive circuit layer 292. The metal anode layer 293 includes a first anode layer 2932, a first insulation layer 2934, and a second anode layer 2936. The first insulation layer 2934 is arranged between the first anode layer 2932 and the second anode layer 2936, and is configured to separate and insulate the first anode layer 2932 from the second anode layer 2936. The first anode layer 2932 includes first signal lines (gate lines) arranged in a first direction, the second anode layer 2936 includes second signal lines (data lines) arranged in a second direction, and the first direction and the second direction may be set to be perpendicular to each other. The first signal lines and the second signal lines each are electrically connected to the first drive unit 248. A drive chip of the display apparatus 20 controls the first drive units 248 through the first signal lines and the second signal lines. The first signal lines and the second signal lines may be made from indium tin oxide (ITO) with high light transmittance to ensure the light transmittance of the light-transmissive display area, while reducing diffraction caused by the first signal lines and the second signal lines. The first signal lines may be arranged at a same layer with the gate electrodes of a second drive unit 268. The second signal lines may be electrically connected to the drain electrode of the first drive unit 248 through a light conductive part in a first via hole 2935.

The metal anode layer 293 may be adjacent to the light-emitting layer 294. The metal anode 2938 of the metal anode layer 293 is directly adjacent to and electrically connected to the first pixel 246 of the light-emitting layer 294. The metal anode layer further includes a second insulation layer 2939 arranged between the metal anode layer 293 and the source electrode of the first drive unit 248. The metal anode 2938 may be electrically connected to the source electrode of the first drive unit 248 through a light conductive part in a via hole for pixel.

It should be noted that, in some embodiments, the metal anode 2938 of the metal anode layer and the second signal lines of the second anode layer 2936 may be located at a same layer. In other words, the metal anode layer and the second anode layer 2936 may be located at a same layer, and the first insulation layer 2934 and the second insulation layer 2939 may be located at a same layer. Alternatively, the metal anode 2938 of the metal anode layer and the second anode layer 2936 may be located at different layers, and the metal anode layer and the second anode layer 2936 are separated and insulated by the second insulation layer 2939.

The light-emitting layer 294 is arranged on the metal anode layer 293. The light-emitting layer 294 includes a pixel definition layer 2942 which is provided with multiple pixel holes. Each of the pixel holes is provided therein with a first pixel 246, which is made from an organic light-emitting material.

The common electrode layer 295 is arranged on the light-emitting layer 294. The metal anode layer 293 and the common electrode layer 295 are disposed at two sides of the first pixels 246, and are configured to cooperatively drive the first pixels 246. The common electrode layer 295 may be made from ITO with high light transmittance.

The planarization layer 296 may be arranged on the common electrode layer 295. After the first pixels 246 are disposed in the pixel holes, the entire pixel holes may not be filled with the first pixels 246. Thus, grooves will be generated after the common electrode layer 295 is disposed on the first pixel 246. The planarization layer 296 may fill and level up the grooves and cover the entire light-emitting layer 294 to protect the light-emitting layer 294, etc.

The touch-sensitive layer 297 may be arranged on the planarization layer 296. The touch-sensitive layer 297 is configured to detect touch-control operations from the user.

A polarizer (not shown) may further be arranged on the touch-sensitive layer 297. The polarizer may be configured to prevent internal light from being transmitted to the outside, so as to prevent the user from seeing internal components such as the drive units. The touch-sensitive layer 297 and the polarizer may be first attached together and then arranged on the planarization layer 296.

It should be noted that, in some embodiments, some structures may be added or omitted as required, which is not limited in the embodiments of the disclosure. For example, at least one of the touch-sensitive layer 297 and the polarizer may be omitted. In another example, a protection layer may be added between the planarization layer 296 and the touch-sensitive layer 297, and the protection layer may be made from the same material as the substrate 291.

The various layers of the first display area 240, except for the first drive units 248 of the drive circuit layer 292 and the metal anodes 2938 of the metal anode layer, are all made from light-transmissive materials, thereby increasing the light transmittance of the first display area 240. For example, the substrate 291, the pixel definition layer 2942, the common electrode layer 295, the planarization layer 296, and the touch-sensitive layer 297 of the first display area 240 may all be made from a light-transmissive material, and the signal lines of the metal anode layer 293 may be made from a light-transmissive material such as ITO or Nano-silver. The TFTs of the drive circuit layer 292 cannot be made from the light-transmissive material, but other parts of the drive circuit layer 292 than the TFTs can be made from the light-transmissive material. It can be understood that, implementations that improve the light transmittance of the first display area by increasing the light transmittance of materials and changing the arrangement of the wires are all within the scope of the disclosure.

It should be noted that, the second display area 220 may adopt a stacked structure similar to that of the first display area 240, and the specific implementation thereof can be referred to the above embodiments, which will not be repeated herein. At least one of the substrate, the pixel definition layer, the common electrode layer, the planarization layer and the touch-sensitive layer of the second display area 220 may be made from the same light-transmissive material as the first display area 240. For example, the substrate may be made from a light-transmissive material such as glass or resin. At least one of the substrate, the pixel definition layer, the common electrode layer, the planarization layer, the touch-control layer of the second display area 220 may be made from a different material from the first display area 240. For example, signal lines of the anode layer of the second display area 220 may be made from a metal or alloy material such as molybdenum (Mo), Mo-Al-Mo film, or silver (Ag). For example, the metal anode of the second display area 220 may be made from a metal material such as Mg, Ag, or Al. The common electrode layer of the second display area 220 may be made from a material such as Mg or Ag. Periphery of the common electrode layer of the second display area 220 and the periphery of the common electrode layer 295 of the first display area 240 are connected to cooperatively constitute a complete common electrode layer 295.

The light-emitting layer of the second display area 220 includes multiple second pixels. The second pixels may be made from the same material with the same light transmittance as the first pixels. Alternatively, the second pixels may be made from a different material from the first pixels such that the light transmittance of the first pixels is greater than the light transmittance of the second pixels.

In order to increase the light transmittance of the first display area 240, the size of the first pixel 246 in the first display area 240 may be set to be greater than the size of the second pixel. Referring to FIG. 7, an exemplary enlarged view of the portion X illustrated in FIG. 2 is shown. The size of the first pixel 246 in the first display area 240 is greater than the size of the second pixel 226. A spacing between two adjacent first pixels 246 is proportional to the size of the first pixels 246. In other words, the larger the first pixels 246, the larger the spacing between two adjacent first pixels 246. Thus, the distribution density of the first pixels 246 in the first display area 240 is lower than the distribution density of the second pixels 226 in the second display area. The light transmittance of the pixel definition layer between the first pixels 246 is greater than the light transmittance of the first pixels 246. Thus, the larger the size of the first pixels 246, the higher the light transmittance of the first display area 240.

In the embodiments, each of the first drive units 248 is covered by the orthographic projection of at least one of the first pixels 246 on the drive circuit layer 292. For example, each of the first drive units 248 is arranged opposite one first pixel 246; or, two first drive units 248 are covered by one first pixel 246, with the first pixel 246 arranged opposite any one of the first pixels 246. Since the light transmittance of the pixel definition layer between the first pixels 246 is greater than the light transmittance of the first pixels 246, by arranging the first drive units 248 below the first pixels 246, the light transmittance of the first display area 240 can be further increased.

For increasing the light transmittance of the first display area 240, the distribution density of the first pixels 246 may be set to be lower than the distribution density of the second pixels. Referring to FIG. 8, another exemplary enlarged view of the portion X illustrated in FIG. 2 is illustrated. The size of the first pixel 246 in the first display area 240 is the same as the size of the second pixel 226, and the spacing between adjacent first pixels 246 is increased with respect to that of the second pixel 226, such that the distribution density of the first pixels 246 is lower than the distribution density of the second pixels 226, and the light transmittance of the pixel definition layer between the first pixels 246 is greater than the light transmittance of the first pixels 246. That is, the lower the distribution density of the first pixels 246, the larger the spacing between the adjacent first pixels 246, and the higher the light transmittance of the first display area 240. Exemplarily, the density of the second pixels in the second display area 220 may be equal to or greater than 400ppi (pixels per inch), the size of the first pixels 246 in the first display area 240 may be four times the size of the second pixels, and the density of the first pixels in the first display area 240 may be 200ppi.

For increasing the light transmittance of the first display area 240, the first drive unit 248 disposed in the first display area 240 may be a drive circuit with a relatively simple structure. Specifically, the second display area 220 includes multiple second drive units, and each of the second drive units is configured to drive a respective one of the second pixels 226. The first drive unit 248 in the first display area 240 may be a drive circuit with a simpler structure compared with the second drive unit in the second display area 220. The number of TFTs included of each of the first drive units 248 is less than the number of TFTs included in each of the second drive units 220. Since the TFTs are opaque, a less number of opaque TFTs in the first drive units 248 means that smaller area is occupied by the TFTs, accordingly, the area of opaque parts of the drive circuit layer can be reduced and the ratio of light-transmissive parts in the drive circuit layer can be increased, which may increase the light transmittance of the drive circuit layer and the first display area 240. For example, the second drive unit may be a *7T1C* drive circuit, and the first drive unit 248 may be a *5T1C*, *4T1C* or *2T1C* circuit.

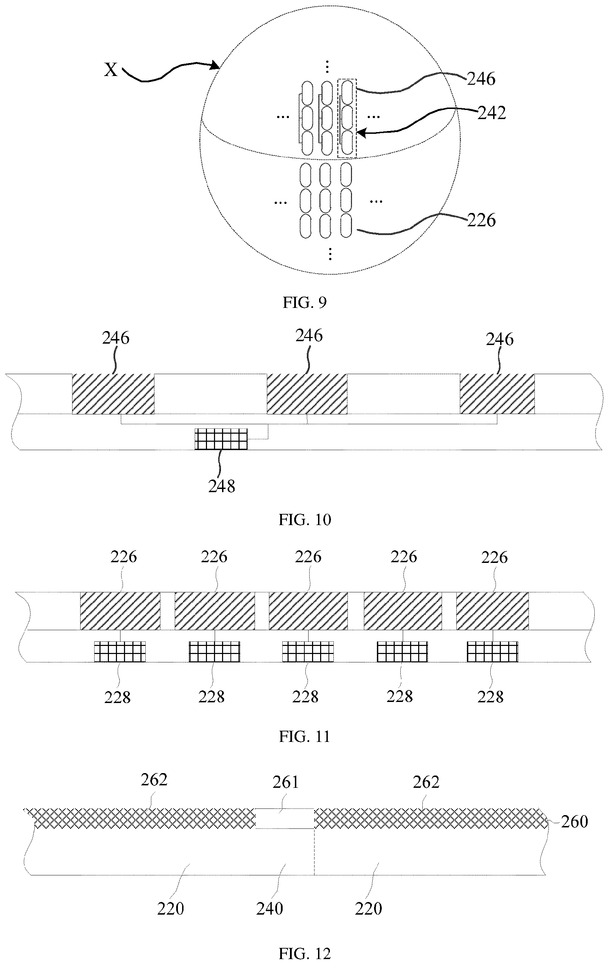

In order to increase the light transmittance of the first display area 240, the distribution density of the first drive units 248 is set to be lower than the distribution density of the second drive units. Referring to FIGS. 9 to 11, FIG. 9 is yet another exemplary enlarged view of the portion X illustrated in FIG. 2, FIG. 10 is a structural schematic diagram of the first pixels and the first drive units of the display apparatus according to the embodiments of the disclosure, and FIG. 11 is a structural schematic diagram of the second pixels and the second drive units of the display apparatus according to the embodiments of the disclosure. The multiple first pixels 246 in the first display area 240 may be divided into multiple pixel sets 242. In other words, the first display area 240 includes multiple pixel sets 242, and each of the pixel sets 242 includes at least two first pixels 246 connected in parallel with each other. The first pixels 246 and the second pixels 226 have a same physical structure. All the first pixels 246 in one pixel set 242 are driven by a same drive unit 248. The light-emitting layer of the first display area 240 and the light-emitting layer of the second display area 220 may be formed in a same process, that is, the light-emitting layer of the first display area 240 and the light-emitting layer of the second display area 220 have no difference. In the second display area 220, each of the second drive units 228 is configured to drive a respective one of the second pixels 226. In the first display area 240, each of the first drive units 248 is configured to drive several first pixels 246 which are connected in parallel. For example, in the first display area 240, at least two of the first pixels 246 with a same display color are connected in parallel, and are driven by one of the first drive units 248. In this implementation, the number of the first drive units 248 can be reduced, the distribution density of the first drive units 248 can be reduced, the number of the first drive units 248 per unit of area is less than the number of the second drive units 228 per unit of area, and the light transmittance of the first display area 240 can be increased with respect to the light transmittance of the second display area 220.

As for the first pixels 246 and the second pixels 226 having a same physical structure, it may mean that the first pixels 246 and the second pixels 226 have the same size, same distribution density, same arrangement and the like. The arrangement may be one of a standard RGB arrangement, a Pentile arrangement, and a Delta arrangement.

The parallel connection of at least two of the first pixels 246 is implemented by connecting the first pixels 246 in the light-emitting layer in parallel, or by connecting the corresponding metal anodes 2938 in the anode layer in parallel.

Referring to FIG. 12, a schematic diagram illustrating a second structure of the display apparatus of the electronic device according to the embodiments of the disclosure. The display apparatus 20 further includes a polarizer 260. The polarizer 260 includes a first polarizing portion 261 and a second polarizing portion 262. The first polarizing portion 261 is arranged at a position corresponding to the first display area 240, and the second polarizing portion 262 is arranged at a position corresponding to the second display area 220, and a light transmittance of the first polarizing portion 261 is greater than a light transmittance of the second polarizing portion 262. The first polarizing portion 261 may be a through hole or be made from a light-transmissive material. For example, a through hole is provided at a position corresponding to the first display area 240, and then the through hole is filled with a transparent material to form the first polarizing portion 261. For another example, a through hole is first provided at a position corresponding to the first display area 240, and then the through hole is filled with a high-transmittance and low-polarizing material to form the first polarizing portion 261. In this implementation, the first polarizing portion 261 can not only provide a high light transmittance, but also prevent light from being transmitted to the outside, so as to prevent the user from seeing the internal structure.

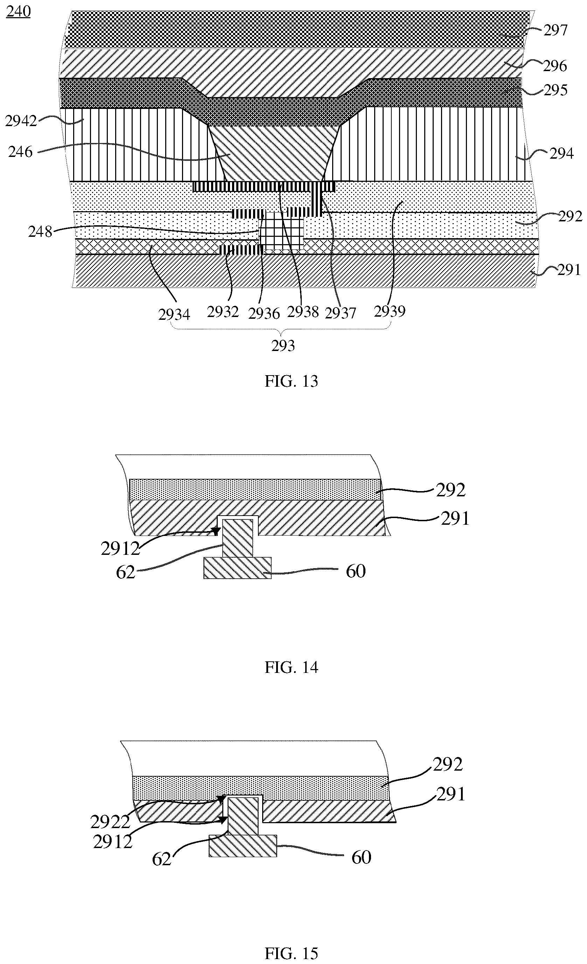

The stacked structure of the first display area 240 may also be implemented in other structures, which is not limited in the embodiments of the disclosure. Exemplarily, the stacked structure in some embodiments is described in reference to FIG. 13, which is a schematic diagram of a fourth stacked structure of the first display area of the display apparatus according to the embodiments of the disclosure. A main difference in the stacked structure of the first display area 240 here from the above embodiments lies in the driver circuit layer and the anode layer. The source electrode and the drain electrode of the TFT of the first drive unit 248 of the first display area 240 are arranged at a same layer, and the source electrode is arranged between the gate electrode and the light-emitting layer.

The metal anode layer 293 is partly arranged on the drive circuit layer 292. The metal anode layer 293 includes a first anode layer 2932, a first insulation layer 2934, and a second anode layer 2936. The first insulation layer 2934 is arranged between the first anode layer 2932 and the second anode layer 2936, and configured to separate and insulate the first anode layer 2932 from the second anode layer 2936. The first anode layer 2932 includes first signal lines (gate lines) arranged in a first direction, the second anode layer 2936 includes second signal lines (data lines) arranged in a second direction, and the first direction and the second direction may be set to be perpendicular to each other. The first signal lines and the second signal lines each are electrically connected to the first drive unit 248. A drive chip of the display apparatus controls the first drive units 248 through the first signal lines and the second signal lines. The first signal lines and the gate electrodes of the first drive units 248 may be located at a same layer, and the second signal lines and the drain electrodes of the first drive unit 248 may be located at a same layer. The metal anode layer 293 may be adjacent to a light-emitting layer 294. The metal anode 2938 of the metal anode layer 293 is directly adjacent to and electrically connected to the first pixel 246 of the light-emitting layer 294. A second insulation layer 2939 is arranged between the metal anode 2938 and the source electrode of the first drive unit 248. The metal anode 2938 may be electrically connected to the source electrode of the first drive unit 248 through a via hole for pixel 2937.

The lens of the camera in the electronic device faces the substrate of the display apparatus. The camera is configured to acquire the signal of external light passing through the first display area for imaging. In order to reduce a space occupied by the camera, the lens of the camera may be arranged to be close to or adjacent to the substrate of the display apparatus. The substrate of the display apparatus is mainly configured to carry the other layers of the display apparatus, and the substrate itself does not require any special functions. Therefore, in order to further reduce the space occupied by the camera, a portion of the camera may be provided in the substrate. FIG. 14 is a structural schematic diagram of the display apparatus and the camera according to the embodiments of the disclosure. A first installation hole 2912 is provided in the substrate at a position corresponding to the camera 60, and at least a part of the camera 60 is provided in this first installation hole 2912. The first installation hole 2912 may be a blind hole. In other words, the thickness of the portion of the substrate 291 corresponding to the camera 60 is less than the thickness of other portions of the substrate, and the substrate 291 is still a complete substrate. This not only does not affect the function of the substrate 291 in carrying the other layers of the display apparatus 20, but also frees up a space to accommodate the camera 60. The installation of the camera 60 onto the first installation hole 2912 may be set according to the size of the first installation hole 2912 and the size of the camera 60. For example, in a case where the space of the first installation hole 2912 is not enough to mount the entire camera 60, the lens 62 of the camera 60 is partially disposed in the first installation hole 2912. In a case where the camera 60 is small enough, the entire camera 60 is disposed in the first installation hole 2912.

Since the drive circuit layer of the first display area is not provided with the first drive units, the drive circuit layer also has no special function, the camera can be disposed in the drive circuit layer of the first display area. Referring to FIG. 15, another structural schematic diagram of the display apparatus and the camera according to embodiments of the disclosure is illustrated. The first installation hole 2912 is a through hole, and the drive circuit layer of the first display area defines a second installation hole 2922 at a position corresponding to the camera 60. The first installation hole 2912 and the second installation hole 2922 are communicated with each other, and at least a part of the camera 60 may be disposed in the second installation hole 2922. For example, the lens 62 of the camera 60 may be located in both the first installation hole 2912 and the second installation hole 2922. The second installation hole 2922 may be a through hole or a blind hole. The first installation hole 2912 and the second installation hole 2922 may be produced after a portion of the stacked structure of the display apparatus 20 is formed. For example, after the driver circuit layer, the anode layer, the light-emitting layer, and the common electrode layer of the display apparatus 20 are all arranged on the substrate 291, the first installation hole 2912 and the second installation hole 2922 are produced at the position corresponding to the lens 62 of the camera 60, by using a laser and the like.

It should be noted that the camera 60 arranged opposite the first display area 240 can serve as a front camera 60 of the electronic device 10. The front camera is generally a camera with an immovable lens. By providing the first installation hole 2912 and the second installation hole 2922 on the substrate 291 and the drive circuit layer 292 of the display apparatus 20 respectively, the camera 60 arranged opposite the first display area 240 can make lens 62 of the camera 60 move, for realizing functions such as autofocus.

It can be understood that the size and shape of the first pixels of the first display area can be set as desired in any one of the above embodiments. For example, the first pixel may be rectangular or circle-like. The circle-like shaped first pixel may include a circle first pixel, an ellipse first pixel, or a rounded rectangle-shaped first pixel, etc. The rounded rectangle-shaped first pixel enables the diffraction of the first display area to be alleviated, due to curved transitions defined at the edges of the circle-like shaped first pixels.

The display apparatus may be in a regular shape, such as a rectangle, a rounded rectangle, or a circle. Obviously, in some other possible embodiments, the display apparatus can also be in an irregular shape, which is not limited in the embodiments of the disclosure.

One or more cameras may be provided below the first display area. The multiple cameras can work cooperatively. For example, two identical cameras may be provided, including a normal camera and a camera with shallow depth of field or a monochrome camera, etc. In addition to the camera, other functional devices can be further provided below the first display area, such as a proximity sensor, a light sensor, a distance sensor, and a fingerprint recognition sensor.

In order to understand the electronic device in the embodiments of the disclosure more comprehensively, the structure of the electronic device will be further described in the following. Referring to FIG. 1, the electronic 10 further includes a housing 40 and the camera 60.

The housing 40 may include a rear cover (not shown) and a frame 420. The frame 420 surrounds a periphery of the rear cover. The display apparatus 20 is disposed in the frame 420. The display apparatus 20 and the rear cover can be two opposite sides of the electronic device 10. The camera 60 is disposed between the rear cover of the housing 40 and the display apparatus 20. The display apparatus 20 may be an organic light-emitting diode (OLED) display apparatus. The display apparatus 20 may be a full-screen. In other words, all the entire display areas of the display apparatus 20 are substantially configured for displaying. The display apparatus 20 may further be provided thereon with a cover plate. The cover plate covers the display apparatus 20 to protect the display apparatus 20, so as to prevent the display apparatus 20 from being scratched or damaged by water. The cover plate can be a transparent glass cover plate, so that the user can see the information displayed on the display apparatus 20 through the cover plate. For example, the cover plate can be a glass cover plate made of sapphire crystal.

The electronic device 10 may further include a circuit board, a battery and a middle plate. The frame 420 is disposed around the middle plate. The frame 420 and the middle plate may form a middle frame of the electronic device 10. Accommodating spaces are defined on both sides of the middle plate by the middle frame and the frame 420. One of the accommodating spaces is configured to accommodate the display apparatus 20, and the other accommodating space is configured to accommodate the circuit board, the battery, and other electronic components or functional assemblies of the electronic device 10.

The middle plate can be in a thin plate-like or sheet-like structure, or can be a hollow frame structure. The middle frame is configured to provide support for the electronic components or functional components in the electronic device 10, so that the electronic components and the functional components in the electronic device 10 can be mounted together. The functional components such as the camera 60, a receiver, the circuit board, the battery, and the like of the electronic device 10 can be mounted on the middle frame or the circuit board for fixing. It can be understood that a material of the middle frame can include metal or plastic, etc.

The circuit board can be mounted on the middle frame. The circuit board may be a main board of the electronic device 10. One or more functional components such as a microphone, a speaker, a receiver, a headphone interface, an acceleration sensor, a gyroscope, a processor and the like can be integrated on the circuit board. Meanwhile, the display apparatus 20 can be electrically connected to the circuit board to control the display of the display apparatus 20 by the processor on the circuit board. Both of the display apparatus 20 and the camera 60 can be electrically connected to the processor. In response to receiving a shooting command, the processor controls the display of the light-transmissive area to be turned off and controls the camera 60 to capture an image through the first display area 240. In response to receiving a command to display an image, the processor controls the second display area 220 and the first display area 240 to cooperatively display the image.

The battery can be mounted on the middle frame. Meanwhile, the battery is electrically connected to the circuit board, such that the battery supplies power to the electronic device 10. The circuit board may be provided with a power management circuit. The power management circuit is configured to distribute voltage provided by the battery to various electronic components in the electronic device 10.

It should be understood that the term "multiple" in the disclosure means two or more.

The display apparatus and the electronic device provided in the embodiments of the disclosure have been described in detail above. Specific examples are used herein to explain the principles and implementations of the disclosure. The descriptions of the above embodiments are only used to facilitate the understanding of the disclosure. In addition, for those skilled in the art, there may be modifications in the specific embodiments and in the scope of the disclosure according to the concept of the disclosure. In summary, the content of the description should not be construed as limitations of the disclosure.

## Claims

1. A display apparatus, comprising a first display area and a second display area which adjoin each other, wherein a light transmittance of the first display area is greater than a light transmittance of the second display area; the first display area comprises a metal anode layer and a drive circuit layer electrically connected to the metal anode layer; the metal anode layer comprises a plurality of metal anodes, and the drive circuit layer comprises a plurality of first drive units; and an orthographic projection of at least one of the first drive units on the metal anode layer is at least partially located within one of the metal anodes.

2. The display apparatus of claim 1, wherein the first display area further comprises a plurality of first pixels, each of the first drive units is configured to drive at least one of the first pixels, and each of the first drive units comprises a plurality of thin-film transistors;
wherein the second display area comprises a plurality of second pixels and a plurality of second drive units, each of the second drive units is configured to drive a respective one of the second pixels, and each of the second drive units comprises a plurality of thin-film transistors; and
wherein the number of the thin-film transistors of each of the second drive units is greater than a number of the thin-film transistors of each of the first drive units.

3. The display apparatus of claim 2, wherein an orthographic projection of at least one of the first pixels on the drive circuit layer covers one of the first drive units.

4. The display apparatus of claim 2, wherein a distribution density of the first pixels in the first display area is lower than a distribution density of the second pixels in the second display area.

5. The display apparatus of claim 2, wherein the plurality of metal anodes are made from an opaque material, and are spaced apart from each other, and an orthographic projection of each of the first pixels on the metal anode layer covers a respective one of the metal anodes.

6. The display apparatus of claim 2, wherein a size of each of the first pixels is greater than a size of any one of the second pixels.

7. The display apparatus of claim 2, wherein a distribution density of the first drive units is lower than a distribution density of the second drive units.

8. The display apparatus of claim 1, wherein the first display area further comprises a plurality of first pixels, the second display area further comprises a plurality of second pixels, the first pixels and the second pixels have a same physical structure; and in the first display area, at least two of the first pixels with a same display color are connected in parallel and driven by a same one of the first drive units.

9. The display apparatus of claim 1, further comprising:
a polarizer comprising a first polarizing portion and a second polarizing portion, wherein the first polarizing portion is arranged at a position corresponding to the first display area, the second polarizing portion is arranged at a position corresponding to the second display area, and a light transmittance of the first polarizing portion is greater than a light transmittance of the second polarizing portion.

10. An electronic device, comprising:
a display apparatus comprising a first display area and a second display area which adjoin each other, wherein a light transmittance of the first display area is greater than a light transmittance of the second display area; the first display area comprises a metal anode layer and a drive circuit layer electrically connected to the metal anode layer; the metal anode layer comprises a plurality of metal anodes, and the drive circuit layer comprises a plurality of first drive units; and an orthographic projection of at least one of the first drive units on the metal anode layer is at least partially located within one of the metal anodes; and
a camera comprising a lens, wherein the lens is arranged to face the first display area, and the camera is configured to acquire a signal of external light passing through the first display area for imaging.

11. The electronic device of claim 10, wherein the display apparatus further comprises a substrate, the drive circuit layer is provided on the substrate, the substrate is provided with a first installation hole at a position corresponding to the first display area, and at least a portion of the lens is located in the first installation hole.

12. The electronic device of claim 11, wherein the drive circuit layer is provided with a second installation hole for receiving the lens, the second installation hole is communicated with the first installation hole, and at least a portion of the lens is located in the second installation hole.

13. The electronic device of claim 10, wherein the first display area further comprises a plurality of first pixels, each of the first drive units is configured to drive at least one of the first pixels, and each of the first drive units comprises a plurality of thin-film transistors;
wherein the second display area comprises a plurality of second pixels and a plurality of second drive units, each of the second drive units is configured to drive a respective one of the second pixels, and each of the second drive units comprises a plurality of thin-film transistors; and
wherein the number of the thin-film transistors of each of the second drive units is greater than the number of the thin-film transistors of each of the first drive units.

14. The electronic device of claim 13, wherein an orthographic projection of at least one of the first pixels on the drive circuit layer covers one of the first drive units.

15. The electronic device of claim 13, wherein a distribution density of the first pixels in the first display area is lower than a distribution density of the second pixels in the second display area.

16. The electronic device of claim 13, wherein the plurality of metal anodes are made from an opaque material, and are spaced apart from each other, and an orthographic projection of each of the first pixels on the metal anode layer covers a respective one of the metal anodes.

17. The electronic device of claim 13, wherein a size of each of the first pixels is greater than a size of any one of the second pixels.

18. The electronic device of claim 13, wherein a distribution density of the first drive units is lower than a distribution density of the second drive units.

19. The electronic device of claim 10, wherein the first display area further comprises a plurality of first pixels, and the second display area further comprises a plurality of second pixels, the first pixels and the second pixels have a same physical structure, and in the first display area, at least two of the first pixels with a same display color are connected in parallel and driven by a same one of the first drive units.

20. The electronic device of claim 10, wherein the display apparatus further comprises:
a polarizer comprising a first polarizing portion and a second polarizing portion, wherein the first polarizing portion is arranged at a position corresponding to the first display area, the second polarizing portion is arranged at a position corresponding to the second display area, and a light transmittance of the first polarizing portion is greater than a light transmittance of the second polarizing portion.
